(19) Europäisches Patentamt / European Patent Office / Office européen des brevets

(11) **EP 4 160 867 B1**

(12) **EUROPEAN PATENT SPECIFICATION**

(45) Date of publication and mention
of the grant of the patent:
**07.08.2024 Bulletin 2024/32**

(21) Application number: **21200782.7**

(22) Date of filing: **04.10.2021**

(51) International Patent Classification (IPC):
**H02J 13/00** $^{(2006.01)}$

(52) Cooperative Patent Classification (CPC):
**H02J 13/00002; H02J 13/00;** Y02E 60/00

(54) **METHOD FOR DETERMINING AN OPTIMAL PLACEMENT OF MEASUREMENT UNITS FOR ESTIMATING THE STATE OF A PHYSICAL POWER DISTRIBUTION GRID**

VERFAHREN ZUR BESTIMMUNG EINER OPTIMALEN PLATZIERUNG VON MESSEINHEITEN ZUR SCHÄTZUNG DES ZUSTANDS EINES PHYSIKALISCHEN STROMVERTEILUNGSNETZES

PROCÉDÉ POUR DÉTERMINER UN EMPLACEMENT OPTIMAL D'UNITÉS DE MESURE D'ESTIMATION DE L'ÉTAT D'UN RÉSEAU DE DISTRIBUTION D'ÉNERGIE PHYSIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**05.04.2023 Bulletin 2023/14**

(73) Proprietor: **KRAKEN TECHNOLOGIES LIMITED**
**London W1D 1NN (GB)**

(72) Inventors:
• **ALIZADEH-MOUSAVI, Omid**
**1800 Vevey (CH)**
• **MOUTIS, Panayiotis**
**NEW-YORK (US)**

(74) Representative: **IK-IP LTD**
**3 Lloyd's Avenue**
**London, Greater London EC3N 3DS (GB)**

(56) References cited:
KR-A- 20210 100 321     US-A1- 2013 304 266
US-A1- 2021 083 474

• FARACH J E ET AL: "AN OPTIMAL PROCEDURE FOR PLACING SENSORS AND ESTIMATING THE LOCATIONS OF HARMONIC SOURCES IN POWER SYSTEMS", IEEE TRANSACTIONS ON POWER DELIVERY, IEEE SERVICE CENTER, NEW YORK, NY, US, vol. 8, no. 3, 1 July 1993 (1993-07-01), pages 1303 - 1310, XP000403125, ISSN: 0885-8977, DOI: 10.1109/61.252656

**Description**

The present invention relates to a method for determining an optimal placement of measurement units for estimating the state of a power distribution grid, and it relates more particularly to such a method allowing to identify an optimal layout comprising a minimum number of measurement units. According to a second aspect, the invention relates to a method for estimating the state of a power distribution grid, and it relates more specifically to such a method requiring no pseudo-measurements. The methods of the invention allow to identify line congestions in the grid and to estimate the voltage profiles with high accuracy.

BACKGROUND OF THE INVENTION

Generally speaking, the state of a power system refers to a set of variables, the values of which can be used to compute the values of all other variables of the power system. Examples of such sets of variables are (i) the voltage magnitudes and phase-angles of all nodes, (ii) the current magnitudes and phase-angles of all branches, (iii) the voltage magnitudes of all nodes and the active and reactive power flows of all branches. In this context, State Estimation, or SE, is the process of inferring the state of an electrical power system using a limited number of measured data at certain locations in the system (hereinafter the "grid"). SE can inform system operators about the real-time status of a grid or allow for 'post-mortem' analysis of faults, events, and regular operation of the grid. The process of placing measurement devices in a grid relies on the nature of the grid, its characteristics, as well as the requirements of the SE per se. In this sense, a brief review of SE at the distribution grid level and of methods for placing measurement devices is presented.
Most prominent distribution grid SE methods are a quasi-real-time set-up for SE of parts of a distribution grid [1], a current-based three-phase formulation [2], a stochastic-aware weighted-least-squares (WLS) formulation [3], a set-up based on line currents and assisted by end-customers' meter data [4] and a SE that is robust to different measurement latencies [5]. Recent efforts in the field pursue formulations of faster estimators and the use of machine learning. In short, a linear distribution grid SE is proposed in [6], constant distribution grid model coefficients for robust and fast SE are discussed in [7], evolutionary algorithms are employed in [8], and a neural network initializes an optimization-formed SE in [9].
At least two major concerns affect the performance and efficiency of distribution grid SE. These concerns are, on the one hand, the location of the measurement devices in a particular distribution grid and, on the other hand, the extent to which measurement devices may be installed in said particular grid. A proper layout of measurement devices is critical as distribution grids contain numerous nodes and lines; hence extensive deployment of such devices implies prohibiting costs. However, using actual grid measurements is critical to the integrity and accuracy of the performed SE. The actual measurements, even if faulty to a greater or lesser extent (equipment accuracy itself can be a consideration), are Gaussian in their nature. This is a benefit to the SE outputs, as the SE can hedge for measurement errors in a robust manner. Most studies estimate that a coverage between 10-50% of any given feeder is required to adequately perform SE [10, 11]. However, as the underlying electrical grid model makes the SE a non-convex problem [13] that cannot be solved accurately in a meaningful time frame, the accuracy of the estimated state is described in terms of probabilistic bounds [12]. Even if only 10% of a feeder is equipped with measurement devices, the costs may still be prohibitive as the voltage phase angle differences in distribution grids are very small and the measurement accuracy to capture them is costly [14]. Whenever real measurements are not available in sufficient numbers in a distribution grid, this lack can be offset with pseudo-measurements (hereinafter "P/Ms"). P/Ms are forecasts or projections of values based on historical data [15], hence, not necessarily Gaussian in nature [16] and, thus, responsible for much uncertainty in the SE accuracy. Section IV in [17] summarizes over a dozen probabilistic and machine learning based methods seeking to curtail the effects of P/Ms to SE. Moreover, the lack or limited availability of historical data in Distribution Systems may mean that P/Ms cannot be obtained in the first place.
US 2021083474 A1 discloses a scenario for optimal placement of measurement units in a power grid.

SUMMARY OF THE INVENTION

It is therefore an object of the present invention to alleviate the above-mentioned problems in the prior art. The present invention achieves this object and others by providing a method for determining an optimal placement of measurement units according to the appended claim 1.
The method of the invention for determining an optimal placement of measurement units takes advantage of the particular way the grid state estimation (SE) is performed. In other word, the method for determining an optimal placement of measurement units for SE, on the one hand, and the SE method as such, on the other hand, are both based on the same inventive concept. According to the invention, the SE method is performed in two stages, first, a Minimum Norm formulation, followed by a Weighted Least Square one. The method for determining an optimal placement of measurement units, and the SE method that it serves, come with theoretical guarantees that line congestions in the grid are captured at a given level of confidence, while the voltage profile of the grid is also estimated with high accuracy.

BRIEF DESCRIPTION OF THE DRAWINGS

Other features and advantages of the present invention will appear upon reading the following description, given solely by way of non-limiting example, and made with reference to the annexed drawings, in which:

- figure 1 is a schematic representation of a medium voltage feeder (part of a grid at the distribution level) comprising 20 nodes (or buses), which forms the setting for an exemplary implementation of the method of the invention;
- figure 2 is a flowchart depicting a particular implementation of the method of the invention for determining an optimal placement of measurement units for estimating the state of a power distribution grid;
- figures 3A and 3B are two representations of a standardized normal distribution, the standardized distribution shown in figure 3A is divided into $0.5 \cdot \sigma$ intervals, while the one shown in figure 3B is divided into $0.25 \cdot \sigma$ intervals;
- figure 4 is a more detailed flowchart depicting a particular implementation of the routine represented by a loop containing boxes 02 and 03 in figure 2;
- figure 5 is a flowchart depicting an alternative version of the implementation depicted in figure 4;
- figure 6 shows an indicative output of an exemplary implementation of the two-stage SE of the invention in one particular operating case of the medium voltage feeder of figure 1.

DETAILED DESCRIPTION OF AN EXAMPLARY IMPLEMENTATION

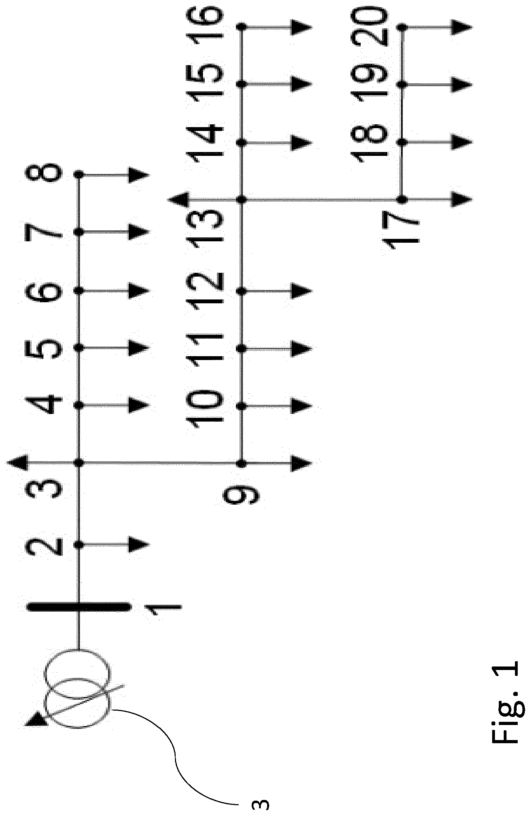

As the field to which the present invention applies is that of electrical power distribution grids, we begin by describing an exemplary distribution grid. An electrical power distribution grid comprises a set of physical nodes (or buses) and a set of physical branches (or lines) for connecting one node to another node. Figure 1 is a one-line diagram of a "real world" 20-bus medium voltage feeder that forms the backbone of an existing power distribution grid located in Switzerland. Measurements form all the transformers (herein after T/Fs) in the distribution grid were recorded over a whole year with a 10' resolution. The complete profiles of numerous operating scenarios can be made available from this data. Furthermore, the line impedances and transformer (T/F) ratings of the feeder are also available. These parameters are given in Table I below. In the following description of an exemplary implementation of the method of the invention, the set of variables used for defining the grid state is made up of the nodal voltages and the branch active and reactive powers. One should note however that a person skilled in the art will be capable of adapting the present exemplary implementation to the case where the state of the grid is defined by a different set of variables.

The power distribution grid is not provided with any distributed generation and storage. One will therefore understand that the critical lines for congestion or reverse power flows are the lines nearest to the in-feeding substation (referenced 3).

Table I

| Bus $i$ | Bus $j$ | $g$ (S) | $b$ (S) | Bus $i$ | Bus $j$ | $g$ (S) | $b$ (S) |
|---|---|---|---|---|---|---|---|
| 1 | 2 | 1.82 | -2.28 | 11 | 12 | 6.98 | -4.55 |
| 2 | 3 | 17.55 | -12.18 | 12 | 13 | 8.92 | -4.15 |
| 3 | 4 | 9.51 | -6.81 | 13 | 14 | 10.83 | -5.23 |
| 3 | 9 | 15.74 | -10.64 | 13 | 17 | 13.53 | -8.88 |
| 4 | 5 | 15.00 | -9.30 | 14 | 15 | 12.78 | -6.34 |
| 5 | 6 | 9.90 | -6.11 | 15 | 16 | 7.15 | -3.47 |
| 6 | 7 | 10.71 | -7.40 | 17 | 18 | 19.34 | -9.52 |
| 7 | 8 | 11.05 | -4.98 | 18 | 19 | 15.12 | -7.44 |
| 9 | 10 | 9.35 | -6.40 | 19 | 20 | 12.74 | -6.35 |
| 10 | 11 | 17.05 | -12.30 | | | | |

| Bus No | $S_n$ (kW) | Bus No | $S_n$ (kW) | Bus No | $S_n$ (kW) | Bus No | $S_n$ (kW) |
|---|---|---|---|---|---|---|---|
| 1 | - | 6 | 630 | 11 | 250 | 16 | 250 |

(continued)

| Bus No | $S_n$ (kW) | Bus No | $S_n$ (kW) | Bus No | $S_n$ (kW) | Bus No | $S_n$ (kW) |
|---|---|---|---|---|---|---|---|
| 2 | 630 | 7 | 400 | 12 | 400 | 17 | 400 |
| 3 | 400 | 8 | 630 | 13 | 800 | 18 | 630 |
| 4 | 800 | 9 | 400 | 14 | 630 | 19 | 630 |
| 5 | 1260 | 10 | 250 | 15 | 400 | 20 | 400 |

Estimating the nodal voltages and the branch active and reactive powers defining the state of a power distribution grid requires the presence of a monitoring infrastructure capable of providing synchronized measurements of voltage and current at a plurality of locations in the power grid. Such a monitoring infrastructure comprises measurement units provided at a selection of physical nodes of the network (in the following disclosure, physical nodes of the network that are equipped with a measurement unit are called "measuring nodes"). Each measurement unit may be arranged to measure the voltage at a particular measuring node (called the nodal voltage) and currents flowing into or out of that particular measuring node (called branch currents), the branch currents can either be currents flowing through branches that are incident on that particular measuring node or currents associated with loads or generations at that particular node. The flows of active and reactive power through a branch that is incident on a particular measuring node can be calculated from the nodal voltage, the branch current through that particular branch, and the phase difference between the nodal voltage and the branch current. This computation can implement locally by each one of the measurement units using the following well known relations:

$$P = V \cdot I \cdot \cos \varphi \qquad \text{and} \qquad Q = V \cdot I \cdot \sin \varphi$$

Furthermore, the net sum of all the active branch power flowing into or out of a node is called the nodal active power, and the net sum of all the reactive power flowing into or out of a node is called the nodal reactive power.

A monitoring infrastructure further comprises communication means arranged for communication between the measurement units and at least one processing unit. It should be noted that the communication means does not necessarily comprise a dedicated transmission network. For example, the monitoring infrastructure may rely instead on the commercial cellular network provided by a mobile operator. According to alternative implementations, however, the communication means for the monitoring infrastructure could be of any type that a person skilled in the art would consider adequate (including power line communication for example).

It should be understood however that saying that the data used for state estimation comes from synchronized measurements at a plurality of locations in the power grid, does not mean that the measurement units must necessarily be highly synchronized. Indeed, the measurement units do not need to be expensive Phasor Measurement Units (PMUs) having a permanent link to a common time reference. Conventional measurement devices capable of timing successive measurements using GPS or NTP for a time reference signal are sufficiently accurate.

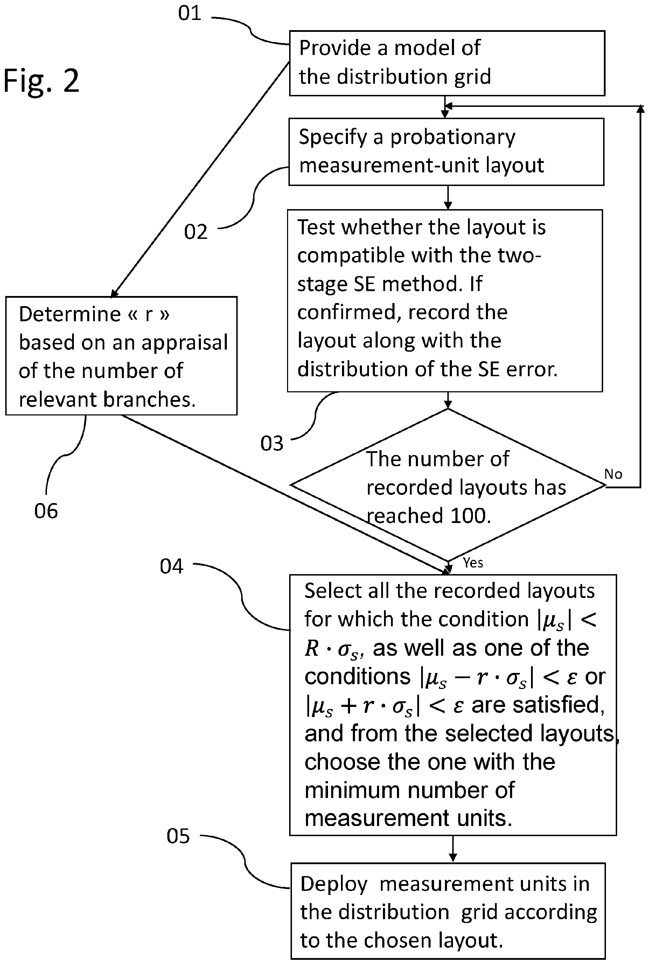

Figure 2 is a flowchart depicting an exemplary implementation of the method of the invention for determining an optimal placement of measurement units for estimating the state of a power distribution grid. The illustrated flowchart comprises six boxes. The first box (referenced 01) generally represents a preliminary step of providing a model of the power distribution grid to which the method should apply. The complete model of a grid typically comprises the grid's admittance matrix containing the topology of the grid, as well as the conductance and susceptance of the branches connecting the nodes, and further comprises the nominal capacity of every branch as well as of the loads and generations at every node.

The second box (referenced 02) represents the task of specifying a hypothetical monitoring infrastructure for the model of the power distribution grid. The hypothetical monitoring infrastructure comprises at least one randomly placed measurement unit. Any node of the power distribution grid that is equipped with a measurement unit according to the hypothetical monitoring infrastructure is called a "measuring node" of the hypothetical monitoring infrastructure.

The third box (referenced 03) represents the task of assessing whether the placement of the at least one measurement unit of the hypothetical monitoring infrastructure is compatible with the two-stage state estimation (SE) method of the invention. The first stage of the state estimation method consists in implementing a Minimum Norm State Estimation for each scenario comprised in a set of stochastic scenarios of the loads and generations in the power distribution grid. For each particular scenario, the Minimum Norm SE uses "measured data" as input. The "measured data" is actually simulated measured data supposed to come from the nodes of the power distribution grid that are provided with measurement units according to the hypothetical monitoring infrastructure. The "measured data" are computed for each particular scenario of loads and generations. In order for the placement of the at least one measurement unit (i.e. the hypothetical monitoring infrastructure) to be compatible with the two-stage SE method, the result of the first stage must be controllable.

The second stage of the state estimation method consists in implementing a Weighted Least Square (WLS) SE for each scenario comprised in the set of stochastic scenarios. The WLS SE uses the same measured data as the Minimum Norm SE as input. Furthermore, the WLS SE also uses states estimated to have non-zero values in the first stage as input. State variables estimated by the Minimum Norm SE for each scenario in the first stage, and used as input in the second state, are called "estimeasurements" or "E/Ms" in the context of the present two-stage state estimation method. In order for the placement of the at least one measurement unit to be compatible with the two-stage SE method, the result of the second stage must be observable. The third box (box 03) further provides that, if the placement of the at least one measurement unit of the hypothetical monitoring infrastructure is compatible with the two-stage state estimation method, one further computes the second stage state estimation error. If the means $\mu_S$ of the estimation error is smaller than A (i.e $|\mu_s| < A$, with $A \in \mathbb{R}^+$), and the standard deviation as is smaller than B (i.e. $|\sigma_s| < B$, with $B \in \mathbb{R}^+$), the means and the standard deviation of the error are recorded along with the measurement-unit placement (to give an example, typical values for A and B are A = 0.15 and B = 0.60. These values are given here in p.u., or in other words "per unit").

The routine consisting in successively implementing the tasks represented in boxes 02 and 03 is repeated until a predefined number of placements (for example one hundred placements) have been recorded. Once the predefined number of placements has been recorded, the method moves on to the fourth box.

The fourth box (referenced 04) generally represents selecting the measurement-unit placements for which the conditions $|\mu_s \pm r \cdot \sigma_s| < \varepsilon$ and $|\mu_s| < R \cdot \sigma_s$ are both satisfied (where $\mu_s$ is the means of the second stage state estimation error, and $\sigma_s$ is its standard deviation). According to the invention $R \le 3$. Both the condition involving "r" and the condition involving "R" are required by the presently described particular implementation that invention. However, it is important to note that either one, or both, of these the conditions can be dispensed with. Accordingly, neither one of them is present in each and every implementation of the method of the invention. The task represented by the fourth box further comprises choosing from the selected measurement-unit placements, the placement with the minimum number of measurement units.

The fifth box (referenced 05) represents the task of deploying the measurement units in the physical distribution grid according to the chosen placement.

The sixth box (referenced 06) generally represents the task of firstly identifying the branches of the power distribution grid that are significantly exposed to the risk of congestion or inverse power flow, of secondly assessing the percentage $\zeta$ of these branches that should be monitored with high accuracy, and of thirdly determining the ratio r of the standard deviation ($\sigma_s$) over the means ($\mu_s$) of a normal distribution, such that the percentage of cases in the normal distribution that are contained in a permittance having a width of no more than $0.5 \cdot \sigma_s$ and that is centered at $\mu_s \pm r \cdot \sigma_s$, or in other words at zero, is equal to $\zeta$.

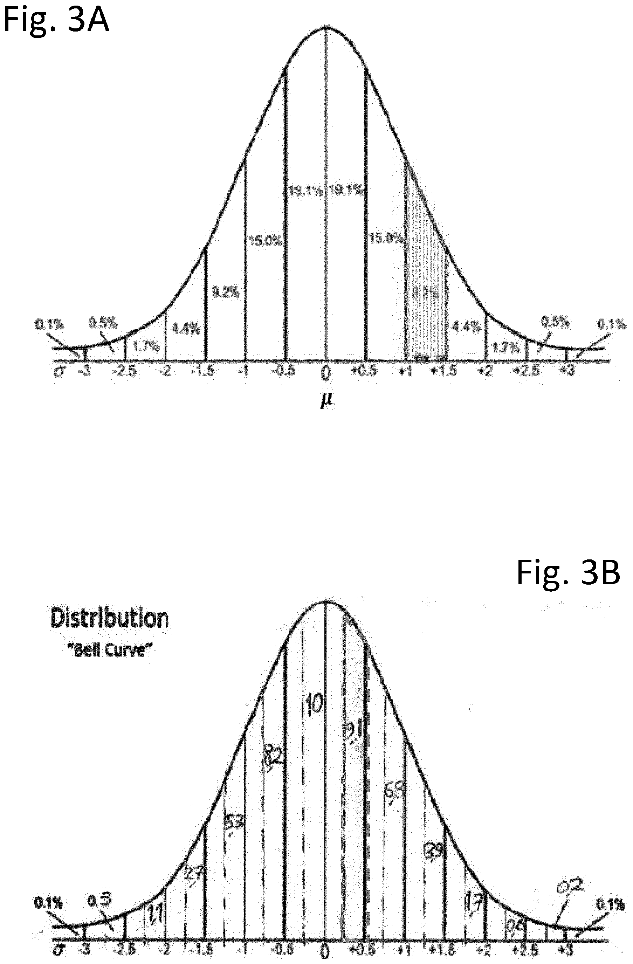

Provided that no pseudo-measurements are used, SE error may be considered to be distributed normally with a statistical mean $\mu$ and a variance $\sigma^2$. Furthermore, the error of the subset S, made up of the estimated state variables for the branches that are significantly exposed to congestion or inverse power flow, will also follow normal distribution of mean $\mu_S$ and variance $\sigma_S^2$. If $\mu_s + r \cdot \sigma_S$ crosses 0, for $r \in \mathbb{R}$, then at least $\zeta < |S|$ states in S are estimated with high accuracy (low error); e.g. if $|S|=100$ and $\mu_S + 1.25 \cdot \sigma_S = 0 \pm \varepsilon$ (i.e. r=1.25), then about $\zeta=9$ states have low SE error, because if we consider that a close vicinity of $\mu_S + r \cdot \sigma_S = 0$ corresponds to the interval $[\mu_S + \sigma_S, \mu_S + 1.5 \cdot \sigma_S]$, it follows that 9.2% of all samples of the normal distribution are in the close vicinity of $\mu_S + r \cdot \sigma_S = 0$ (refer to Figure 3A) (it should be noted that the same analysis also applies if $\mu_S - r \cdot \sigma_S$ crosses 0). Inversely, if $\zeta$ states in S must be estimated accurately, an r may be selected so that, if $\mu_S + r \cdot \sigma_S$ crosses 0, then the interval $[\mu_S + \sigma_S, \mu_S + 1.5 \cdot \sigma_S]$ contains a portion of $|S|$ equal to $\zeta$.

It should be noted that the value of "r" depends on the width of the interval (hereinafter the "permittance") that is considered to embody the close vicinity of $\mu_S + r \cdot \sigma_S = 0$. For example, if instead of being equal to $0.5 \cdot \sigma_S$ as before, the permittance is equal to $0.25 \cdot \sigma_S$, and the number of states that have to be estimated accurately is still $\zeta=9$, then the estimated value of "r" will be 0.375, because the interval $[\mu_S + 0.25 \cdot \sigma_S, \mu_S + 0.5 \cdot \sigma_S]$ of a normal distribution contains 9.1% of the cases (refer to Figure 3B). One will understand that the lower the interval permittance, the smaller the value of "r". Furthermore as $\mu_S + r \cdot \sigma_S = 0$, the smaller the value of "r", the smaller the value of $\mu_S$. It follows that if the interval permittance is smaller, the selected placements will require a greater number of measurement units. On the other hand, if the permittance is substantially greater than $0.5 \cdot \sigma_S$, the number of states that are estimated accurately will be questionable.

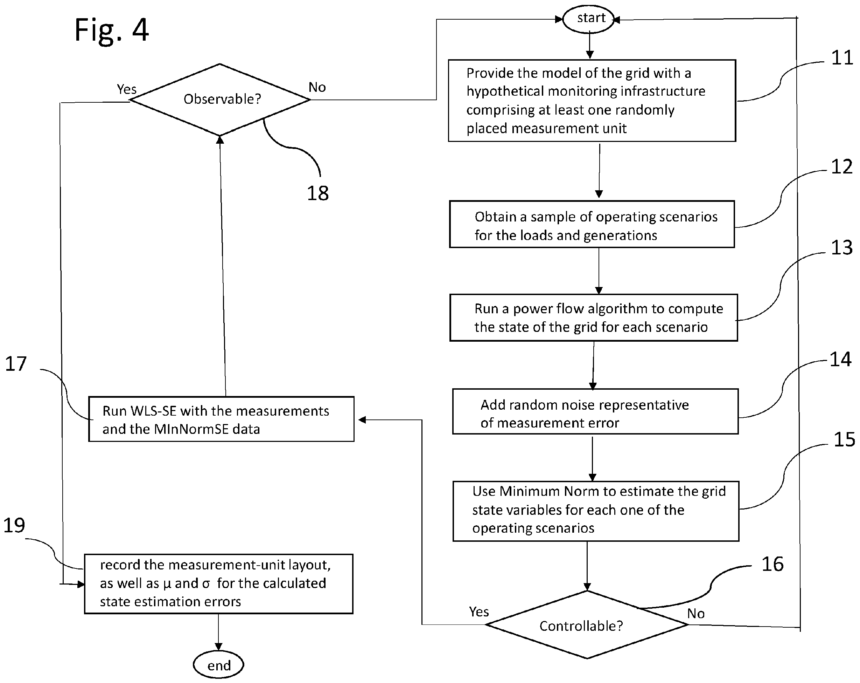

Figure 4 is a flowchart illustrating in greater detail a particular implementation of the routine represented by a loop containing boxes 02 and 03 of Figure 2. The first box of Figure 4 (box 11) is identical to box 02 of Figure 2.

The second box of Figure 4 (box 12) consists in the task of obtaining a set of stochastic scenarios for the loads and generations in the power distribution grid. The obtained set should contain at least about 1000 different scenarios for (i.e. operating conditions of) the loads and generations (i.e. demand loading, as well as Distributed Generation and Storage (DGS) if present). The stochastic scenarios for the loads and generations can be obtained either from simulations (for example by running a Monte Carlo) or from actual data (if many measured profiles of loads and generations in the power distribution grid are available).

The third box of Figure 4 (box 13) consists in running a power flow algorithm in order to simulate the power flow in the modelled distribution grid for each one of the operating scenarios contained in the sample that was obtained during the previous step, and further to compute the state of the power distribution grid for each scenario. The values computed by the power flow algorithm for voltages at measuring nodes of the hypothetical monitoring infrastructure, for currents through branches that are incident on measuring nodes of the hypothetical monitoring infrastructure, as well as for currents associated with power injections at measuring nodes of the hypothetical monitoring infrastructure, are referred to hereafter as "measured values", and the corresponding values of the active and reactive powers are also referred to as "measured values".

The fourth box of Figure 4 (box 14) consists in adding random noise to the "measured values" obtained in the previous step. The added noise should be representative of the accuracy level of the measurement units. For instances, for a measurement device with 99.9% accuracy, the added random noise can be calculated from a normal distribution with a mean value of 0 and standard deviation of 0.1% of the "measured value".

The fifth box of Figure 4 (box 15) consists in using Minimum Norm to identify an objective function for the states of the power distribution grid, as well as to estimate the grid state variables for each one of the operating scenarios obtained in the second step. For each scenario, this Minimum Norm SE uses the corresponding measured values obtained in the fourth step as input. As previously noted, the state estimation method of the invention is performed in two stages, first, a Minimum Norm formulation, followed by a Weighted Least Squares one. One will therefore understand that the fifth box (box 15) corresponds to the first stage of the SE.

In the first stage, the SE problem can be formulated as the following Minimum Norm optimization problem:

$$\text{find} \quad \min \|\tilde{x}\|_2$$
$$\text{subject to} \quad \tilde{x} = \hat{x}$$
$$f(\tilde{x}, \hat{x}) = 0$$

where $\tilde{x}$ is all grid state variables, $\hat{x}$ is the measured values, and the model of power flow equations is given by $f(\tilde{x}, \hat{x})$.

According to an exemplary implementation that does not require using PMUs, the method uses a known power flow approximation that is linear for a radial distribution grid when solved for the square of bus voltage magnitudes [18]. It should be understood however that the present invention does not require using a linear approximation. According to the above-mentioned exemplary implementation, the first stage of the two-stage SE method of the invention is defined as follows:

1$^\text{st}$ stage:

$$\min \left\| \tilde{V}_1^2, \dots, \tilde{p}_{12}, \dots, \tilde{q}_{12}, \dots, \tilde{P}_1, \dots, \tilde{Q}_1 \dots \right\|_2$$

s.t.

$$\tilde{V}_i^2 = \hat{V}_i^2, \ \tilde{P}_i = \hat{P}_i, \ \tilde{Q}_i = \hat{Q}_i, \ \tilde{p}_{ij} = \hat{p}_{ij}, \ \tilde{q}_{ij} = \hat{q}_{ij}$$

$$\left. \begin{array}{l} \hat{V}_i^2 = \tilde{V}_j^2 - 2\tilde{p}_{ij}r_{ij} - 2\tilde{q}_{ij}x_{ij} \\ \tilde{V}_j^2 = \hat{V}_i^2 - 2\tilde{p}_{ji}r_{ji} - 2\tilde{q}_{ji}x_{ji} \\ \tilde{V}_i^2 = \tilde{V}_j^2 - 2\hat{p}_{ij}r_{ij} - 2\tilde{q}_{ij}x_{ij} \\ \tilde{V}_i^2 = \tilde{V}_j^2 - 2\tilde{p}_{ij}r_{ij} - 2\hat{q}_{ji}x_{ij} \end{array} \right\}$$

$$\left.\begin{array}{l} \hat{P}_i = \tilde{V}_i^2 real(Y_{ii}) + \sum \tilde{p}_{ij} \\ \hat{Q}_i = \tilde{V}_i^2 imag(Y_{ii}) + \sum \tilde{q}_{ij} \\ \tilde{P}_i = \tilde{V}_i^2 real(Y_{ii}) + \sum_{k \neq i} \tilde{p}_{kj} + \hat{p}_{ij} \\ \tilde{Q}_i = \tilde{V}_i^2 imag(Y_{ii}) + \sum_{k \neq i} \tilde{q}_{kj} + \hat{q}_{ij} \end{array}\right\}$$

where *V, p, q, r* and *x* are the voltage magnitude, active and reactive power flows, line resistance and reactance, respectively, between buses *i* and *j*. Where, beyond the previously defined variables, *Y, P* and *Q* denote the DS admittance matrix, active and reactive power injections, respectively, while values under hats denote measured values and those under tildes denote first stage estimated values of state variables (hereinafter "estimeasurements" or "EIMs").

The sixth box of Figure 4 (box 16) represents testing the optimization problem defined in the previous step to assess whether it makes the power distribution grid controllable. If the outcome of the test is negative, the process returns to the first box (box 11) as the previous version of the hypothetical monitoring infrastructure is replaced with a new version. The placement of the measurement units in the new version of the hypothetical monitoring infrastructure must be different from the placement of the measurement units in the previous version. If the outcome of the test is positive, the process moves on to the next step (box 17).

The seventh box if Figure 4 (box 17) consists in using Weighted Least Square to identify an objective function for the states of the power distribution grid, as well as to estimate the grid state variables for each one of the operating scenarios obtained in box 12. For each scenario, this Weighted Least Square SE uses the corresponding measured values and EIMs obtained inbox 15 as input. The seventh box corresponds to the second stage of the SE.

In the second stage, the SE problem can be formulated as the following Weighted Least Square problem:

find: $\min \|x - \tilde{x}, x - \hat{x}\|_2$
subject to $f(\tilde{x}, \hat{x}, x) = 0$
where x is all grid state variables, $\tilde{x}$ is all grid state variables calculated at stage 1, $\hat{x}$ is the measurement values, and the model of power flow equations is given by $f(\tilde{x}, \hat{x}, x)$.

According to an exemplary implementation that does not require using PMUs, the second stage of the two-stage SE method of the invention is defined as follows:
2nd stage:

$$\min (z - Ay)' \cdot W \cdot (z - Ay)$$

for

$$y = [\tilde{V}_1^2, ..., \tilde{p}_{12}, ..., \tilde{q}_{12}, ...]$$

s.t.

$$Ay = z \Rightarrow \{(1), (2), (3), (4)\}$$

$$V_i^2 = \{\tilde{V}_i^2 \lor \tilde{V}_i^2 \lor 1\}, \; p_{ij} = \{\hat{p}_{ij} \lor \tilde{p}_{ij}\}, \; q_{ij} = \{\hat{p}_{ij} \lor \tilde{p}_{ij}\} \; (1)$$

$$\left.\begin{array}{l} \{\hat{V}_i^2 \lor \tilde{V}_i^2 \lor 1\} = V_j^2 - 2p_{ij}r_{ij} - 2q_{ij}x_{ij} \\ V_j^2 = \{\hat{V}_i^2 \lor \tilde{V}_i^2 \lor 1\} - 2p_{ji}r_{ji} - 2q_{ji}x_{ji} \\ V_i^2 = V_j^2 - 2\{\hat{p}_{ij} \lor \tilde{p}_{ij}\}r_{ij} - 2q_{ij}x_{ij} \\ V_i^2 = V_j^2 - 2p_{ij}r_{ij} - 2\{\hat{q}_{ij} \lor \tilde{q}_{ij}\}x_{ij} \end{array}\right\} \; (2)$$

$$\left.\begin{array}{l}\{\hat{P}_i \vee \tilde{P}_i\} = V_i^2 real(Y_{ii}) + \sum p_{ij} \\ \{\hat{Q}_i \vee \tilde{Q}_i\} = V_i^2 imag(Y_{ii}) + \sum q_{ij}\end{array}\right\} \quad (3)$$

$$-p_{ji} = \{\hat{p}_{ij} \vee \tilde{p}_{ij}\}, \quad -q_{ji} = \{\hat{p}_{ij} \vee \tilde{p}_{ij}\} \quad (4)$$

Where, as in the first step, *V, p, q, r* and *x* are the voltage magnitude, active and reactive power flows, line resistance and reactance, respectively, between buses i and *j*; and *Y, P* and *Q* denote the DS admittance matrix, active and reactive power injections, respectively, while values under hats denote measured values and those under tildes denote EIMs. Variables without hats or tildes are the second stage estimated values of the state variables. For the case of voltage magnitude, the nominal voltage may be used as a kind of pseudo-measurement (P/M) (i.e. a P/M of 1 p.u.), if neither a measured value nor an E/M is available.

The eighth box of Figure 4 (box 18) consists in testing the optimization problem defined in the previous step to assess whether it makes the power distribution grid observable. If the outcome of the test is negative, the process returns to the first box (box 11) as the previous version of the hypothetical monitoring infrastructure is replaced with a new version. The placement of the measurement units in the new version of the hypothetical monitoring infrastructure should be different from the placement of the measurement units in all previous versions. If the outcome of the test is positive, the process moves on to the next step (box 19).

The nineth box (box 19) represents firstly the task of calculating the second stage SE errors for a subset S of the estimated grid state variables (according to some implementations, the subset S may be equal to the entire set of estimated grid state variables). The second stage SE errors can be calculated by comparing the grid state variables estimated in box 17 with the ones previously calculated in box 13. Secondly, box 19 also represents the task of the recording the placement of the measurement units in the current version of the hypothetical monitoring infrastructure, along with the means ($\mu_S$) and the standard deviation ($\sigma_S$) of the calculated second stage SE errors for the subset *S* of the estimated grid state variables. One will understand that, in case where the subset S is not equal to the entire set of estimated grid state variables, the subset S should comprise the estimated state variables that concern branches of the power distribution grid that were identified earlier as being significantly exposed to congestion or inverse power flow. In the case of implementations of the method that comprise a step of determining "*r*" (box 06 of Figure 2), the subset S can be made up of the branches of the power distribution grid that were identified as being significantly exposed to congestion or inverse power flow in the course of determining "*r*".

The routine illustrated in Figure 4 (comprising each of the boxes 11 to 19) is repeated a predetermined number of times (for example one hundred times), so that a predetermined number of measurement-unit placements are recorded along with the values of the means and of the standard deviation of the SE errors associated with that particular measurement-unit placement.

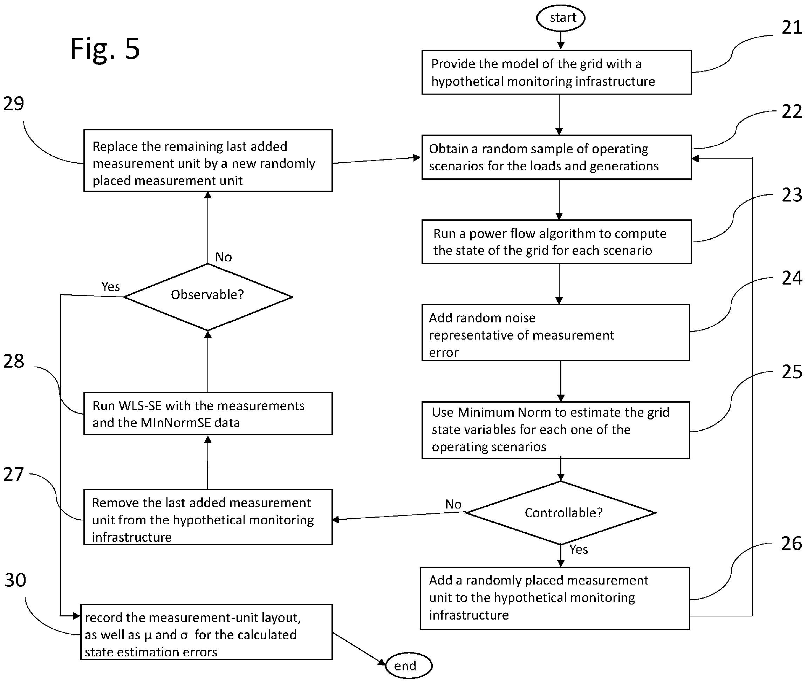

Figure 5 is a flowchart depicting an alternative version of the exemplary implementation of the method of the invention illustrated by the flowchart of figure 4. The tasks represented by boxes 21 to 25 of Figure 5 can be identical to the boxes represented by boxes 11 to 15 of Figure 4. Furthermore, boxes 28 and 30 of Figure 5 can be identical to boxes 17 and 19 of Figure 4. A first difference between the flowcharts of Figures 4 and 5 concerns the effect of the controllability test represented by box 16 in Figure 4. Indeed, according to Figure 5, when the outcome of the controllability test is positive, the illustrated implementation returns to box 22 and adds an additional randomly placed measurement unit to the hypothetical monitoring infrastructure, instead of moving on to the second stage of the SE method right away. When the outcome of the controllability test is negative, on the other hand, the last added measurement unit is removed from the hypothetical monitoring infrastructure as indicated by box 27. Removing the last added measurement unit makes the power distribution grid controllable again. The implementation of the method then moves on to the second stage of the SE method represented by box 28.

A second difference between the flowcharts of Figures 4 and 5 concerns what happens in the case where the outcome of the observability test represented by box 18 (Figure 4) is negative. According to Figure 4, in this case, the process returns to box 11 as previously described, and the current version of hypothetical monitoring infrastructure is replaced by a new version. According to Figure 5, on the other hand, only one of the measurement units of the current hypothetical monitoring infrastructure is removed and replaced by new randomly placed measurement unit. According to a preferred version of the implementation illustrated by the flowchart of Figure 5, the measurement unit that is removed and replaced by new randomly placed measurement unit is the remaining last added measurement unit.

EXAMPLE

By way of example, we now describe how the method illustrated by the flowchart of Figure 2 can be applied to the 20-bus medium voltage feeder of Figure 1. As previously explained, the method begins with the step of providing a model of the distribution grid (Box 01 of Figure 2). The model of the distribution grid of the present example comprises all the conductances and susceptances listed in Table 1, as well as the nominal capacity of every branch. In the present example, each branch has a nominal capacity equal to 8MVA.

Measurements from all the T/Fs in this grid over a whole year period in 10' detail are available (about 53000 entries per T/F). A power flow algorithm is executed to retrieve all operating data for every 10' interval. The retrieved data provides an objective way of identifying the branches of the power distribution grid that are the most exposed to congestion or reverse power flow. Indeed, these branches are the ones through which pass the highest active and reactive power flows (by absolute value). The identified active and reactive power flows are $p_{1-2}$ and $q_{1-2}$ through branch 1-2, $p_{2-3}$ and $q_{2-3}$ through branch 2-3, and finally $p_{3-9}$ and $q_{3-9}$ through branch 3-9. The subset $S_P$ comprises the state variables $p_{1-2}$, $p_{2-1}$, $p_{2-3}$, $p_{3-2}$, $p_{3-9}$ and $p_{9-3}$, and the subset $S_Q$ comprises the state variables $q_{1-2}$, $q_{2-1}$, $q_{2-3}$, $q_{3-2}$, $q_{3-9}$ and $q_{9-3}$. The highest active power flows (by absolute value) in the power distribution grid are $p_{1-2}$, $p_{2-3}$, $p_{3-9}$ and the highest reactive power flows (by absolute value) in the power distribution grid are $q_{1-2}$, $q_{2-3}$, $q_{3-9}$. The number of critical active $|S_p|$ and reactive $|S_Q|$ power flows are therefore both considered to be equal to six (k=6).

As a complete profile is available for numerous operating scenarios of the distribution grid, the power flow data of about 1000 different cases is used to obtain a random sample of operating scenarios of the load, instead of using the results of a (Monte Carlo) simulation (Box 12 of Figure 4 and Box 22 of Figure 5).

Among all the recorded measurement-unit placements (box 03 of Figure 2, box 19 of Figure 4 and box 30 of Figure 5), there were 107 placements for which the maximum voltage magnitude estimate error is less than 1%, and the measurement errors for the subsets of state variables $S_P$ & $S_Q$ meet the conditions of $\mu_s + r \cdot \sigma_s$ crossing 0 at $r \approx 0.6$ (i.e. $\zeta = 1$). Table II presents 4 of these measurement placements with their $\mu_s$ and $\sigma_s$ for active and reactive power flows as well as the average and maximum voltage magnitude estimate errors.

Table II.

| \|z\| | | $\mu$ | $\sigma$ | $\Delta V_{mean}$ (%) | $\Delta V_{max}$ (%) | Placement |
|---|---|---|---|---|---|---|
| 4 | $S_P$ | -0.01 | 0.07 | 0.08 | 0.16 | {1, 7, 9, 10} |
| | $S_Q$ | -0.14 | 0.54 | | | |
| 7 | $S_P$ | 0.02 | -0.24 | 0.05 | 0.14 | {1, 2, 7, 9, 14, 15, 17} |
| | $S_Q$ | -0.15 | 0.36 | | | |
| 11 | $S_P$ | -0.02 | 0.62 | 0.04 | 0.10 | {1, 5, 7, 9, 10, 11, 14, 17, 18, 19, 20} |
| | $S_Q$ | -0.01 | 0.67 | | | |
| 17 | $S_P$ | -0.01 | 0.07 | 0.03 | 0.09 | {1, 2, 3, 4, 5, 6, 7, 8, 9, 10, 12, 13, 14, 16, 17, 18, 20} |
| | $S_Q$ | -0.01 | 0.05 | | | |

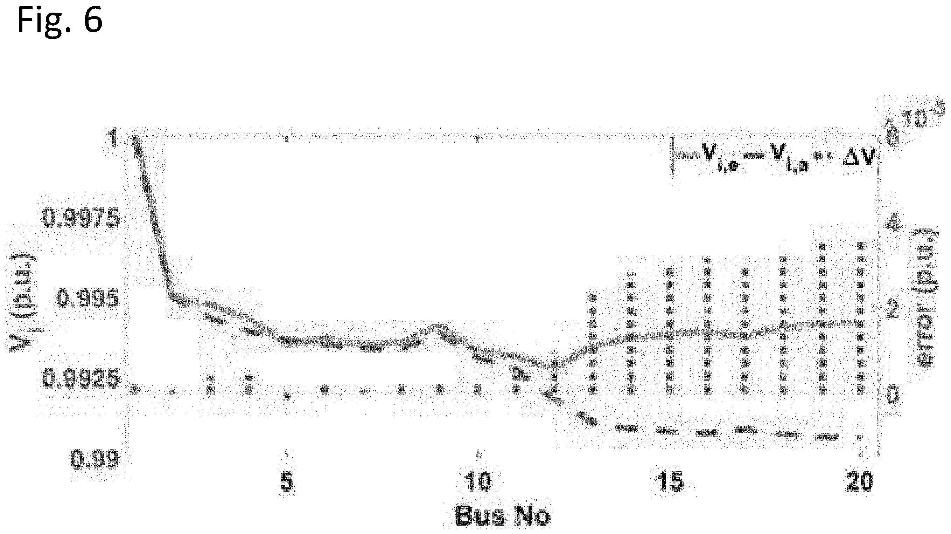

Figure 6 shows an indicative output of an exemplary implementation of the two-stage SE of the invention in one particular operating case of the medium voltage feeder of figure 1. The x-axis in Figure 6 shows the 20 buses of the feeder, while the y-axis on the left shows the voltages in p.u. (per unit of the nominal voltage), and the y-axis on the right shows the error between estimated and actual values. The estimated voltage profile of every node is given in continuous pink and the actual voltage profile is shown by a red-dashed line. The estimated and actual voltages should be read from y-axis on the left (errors for the estimated voltage are in the order of $10^{-3}$). The values for the estimation error for every node are shown in dotted brown. These values should be read from the y-axis on the right. One will understand that voltage estimate errors are very small, i.e. less than 0.004 p.u. and that the error is even smaller for the nodes closer to the primary substation (slack node).

REFERENCES

[1] I. Roytelman and S. Shahidehpour, "State estimation for electric power distribution systems in quasi real-time conditions," IEEE Transactions on Power Delivery, vol. 8, no. 4, pp. 2009-2015, 1993.

[2] C. Lu, J. Teng, and W.-H. Liu, "Distribution system state estimation," IEEE Transactions on Power systems, vol.

10, no. 1, pp. 229-240, 1995.

[3] K. Li, "State estimation for power distribution system and measurement impacts," IEEE Transactions on Power Systems, vol. 11, no. 2, pp. 911-916, 1996.

[4] H. Wang and N. N. Schulz, "A revised branch current-based distribution system state estimation algorithm and meter placement impact," IEEE Transactions on Power Systems, vol. 19, no. 1, pp. 207-213, 2004.

[5] J. Wu, Y. He, and N. Jenkins, "A robust state estimator for medium voltage distribution networks," IEEE Transactions on Power Systems, vol. 28, no. 2, pp. 1008-1016, 2013.

[6] D. A. Haughton and G. T. Heydt, "A linear state estimation formulation for smart distribution systems," IEEE Transactions on Power Systems, vol. 28, no. 2, pp. 1187-1195, 2012.

[7] M. C. de Almeida and L. F. Ochoa, "An improved three-phase AMB distribution system state estimator," IEEE Transactions on Power Systems, vol. 32, no. 2, pp. 1463-1473, 2016.

[8] S. Prasad and D. V. Kumar, "Trade-offs in PMU and IED deployment for active distribution state estimation using multi-objective evolutionary algorithm," IEEE Transactions on Instrumentation and Measurement, vol. 67, no. 6, pp. 1298-1307, 2018.

[9] A. S. Zamzam, X. Fu, and N. D. Sidiropoulos, "Data-driven learning-based optimization for distribution system state estimation," IEEE Transactions on Power Systems, vol. 34, no. 6, pp. 4796-4805, 2019.

[10] J. Liu, J. Tang, F. Ponci, A. Monti, C. Muscas, and P. A. Pegoraro, "Trade-offs in PMU deployment for state estimation in active distribution grids," IEEE Transactions on Smart Grid, vol. 3, no. 2, pp. 915-924, 2012.

[11] J. Liu, F. Ponci, A. Monti, C. Muscas, P. A. Pegoraro, and S. Sulis, "Optimal meter placement for robust measurement systems in active distribution grids," IEEE Transactions on Instrumentation and Measurement, vol. 63, no. 5, pp. 1096-1105, 2014.

[12] R. Singh, B. C. Pal, and R. B. Vinter, "Measurement placement in distribution system state estimation," IEEE Transactions on Power Systems, vol. 24, no. 2, pp. 668-675, 2009.

[13] J. A. Taylor, Convex optimization of power systems. Cambridge University Press, 2015.

[14] A. von Meier, E. Stewart, A. McEachern, M. Andersen, and L. Mehrmanesh, "Precision micro-synchrophasors for distribution systems: A summary of applications," IEEE Transactions on Smart Grid, vol. 8, no. 6, pp. 2926-2936, 2017.

[15] A. Monticelli, "Electric power system state estimation," Proceedings of the IEEE, vol. 88, no. 2, pp. 262-282, 2000.

[16] P. A. Pegoraro et al., "Bayesian approach for distribution system state estimation with non-Gaussian uncertainty models," IEEE Transactions on Instrumentation and Measurement, vol. 66, no. 11, pp. 2957-2966, 2017.

[17] K. Dehghanpour, Z. Wang, J. Wang, Y. Yuan, and F. Bu, "A survey on state estimation techniques and challenges in smart distribution systems," IEEE Transactions on Smart Grid, vol. 10, no. 2, pp. 2312-2322, 2018.

[18] L. W. Gan, S. H. Low, and Ieee, "Convex Relaxations and Linear Approximation for Optimal Power Flow in Multiphase Radial Networks", 2014 Power System Computation Conference (Pscc), 2014.

**Claims**

1. A method for determining an optimal placement of measurement units for estimating the state of a physical power distribution grid comprising a set of nodes and a set of branches, the method comprising the following steps:

   I. provide a model of the power distribution grid comprising the topology (nodes), the lines with their resistance and inductance and nominal capacity, as well as the nominal capacity of connected loads and generations at every node;

II. specify a hypothetical monitoring infrastructure for the model of the power distribution grid, the hypothetical monitoring infrastructure comprising at least one randomly placed measurement unit, wherein any node of the power distribution grid that is equipped with a measurement unit according to the hypothetical monitoring infrastructure is called hereafter a "measuring node";

III. assess whether the placement of the at least one measurement unit in the monitoring infrastructure is compatible with a two-stage state estimation method, wherein the first stage of the method consists in implementing a Minimum Norm SE for each scenario comprised in a set of stochastic scenarios for loads and generations, the Minimum Norm SE using as input for each particular scenario, measured data corresponding to the particular scenario, since in order for the placement of the at least one measurement unit to be compatible with the two-stage SE method, the result of the first stage must be controllable, and wherein the second stage of the method consists in implementing a Weighted Least Square (WLS) SE for each scenario in the set of stochastic scenarios, using as input for each particular scenario, the measured data corresponding to the particular scenario and non-zero values estimated in the first stage of the method for the particular scenario, since in order for the placement of the at least one measurement unit to be compatible with the two-stage SE method, the result of the second stage must be observable;

IV. if the placement of the at least one measurement unit is compatible with the two-stage state estimation method, determine the means and the standard deviation of the second stage State Estimation error, and record the placement of the at least one measurement unit along with said means and said standard deviation; repeat steps II to IV until at least one hundred measurement-unit placements have been recorded;

V. select a measurement-unit placement that comprises a minimum number of measurement units from the recorded measurement-unit placements that satisfy the condition $|\mu_s| < A$, with $A \in \mathbb{R}^+$ , and/or the condition $|\sigma_s| < B$, with $B \in \mathbb{R}^+$ ;

VI. provide the physical power distribution grid with a monitoring infrastructure comprising measurement units placed according to the measurement-unit placement selected in step V.

**2.** The method for determining an optimal placement of measurement units according to claim 1, wherein when implementing step V, the measurement-unit placement that comprises a minimum number of measurement units is selected from the recorded measurement-unit placements that also satisfy the condition $|\mu_s| < R \cdot \sigma_s$ with $R \in \mathbb{R}^+$ (for example $|\mu_s| < 3 \cdot \sigma_s$).

**3.** The method for determining an optimal placement of measurement units according to claim 1 or 2, wherein it comprises an additional step between steps I and V, said additional step consisting in:

- determining "*r*" based on an appraisal of the number of branches that should be monitored for congestion or reverse flow; and

wherein, when implementing step V, the measurement-unit placement that comprises a minimum number of measurement units is selected from the recorded measurement-unit placements that also satisfy at least one of the two conditions $|\mu_s| - r \cdot \sigma_s| < \varepsilon$ and $|\mu_s + r \cdot \sigma_s| < \varepsilon$ (for example $|\mu_s - r \cdot \sigma_s| < 10^{-3}$ and $|\mu_s| + r \cdot \sigma_s| < 10^{-3}$).

**4.** The method for determining an optimal placement of measurement units according to claim 3, wherein the additional step of determining "*r*" comprises the following sub-steps:

- identify branches of the power distribution grid that are most exposed to congestion or inverse power flow;
- estimate the percentage of the active and reactive power flows through the identified branches, that should be monitored with high accuracy;
- determine $r$ as the ratio of the standard deviation ($\sigma_s$) over the means ($\mu_s$) of a normal distribution, such that the percentage of cases in the normal distribution that are contained in a permittance centered at zero and having a width of no more than about $0.5 \cdot \sigma_s$ is equal to said estimated percentage.

**5.** The method for determining an optimal placement of measurement units according to claim 4, wherein the permittance has a width of $0.5 \cdot \sigma_s$.

6. The method for determining an optimal placement of measurement units according to any one of the preceding claims, wherein step III comprises the following sub-steps:

a) obtain a set of stochastic scenarios for loads and generations in the power distribution grid;

b) use a power flow algorithm in order to simulate the power flow in the distribution grid for each one of the stochastic scenarios comprised in the set so as to calculate the respective states of the power distribution grid, the values of nodal voltages calculated for measuring nodes, as well as the values of branch currents calculated for branches incident on measuring nodes, are referred to hereafter as "measured values", and the corresponding values of active and reactive powers are also referred to as "measured values";

c) use Minimum Norm to identify an optimization problem for the states of the power distribution grid, as well to estimate the grid state variables for each one of the stochastic scenarios obtained in step a), measured values obtained in step b) for each particular stochastic scenario being used as input for estimating the grid state variables for the particular stochastic scenario.

d) if the optimization problem identified in sub-step c) makes the power distribution grid controllable, use weighted least square to identify an objective function for the states of the power distribution grid, as well to estimate the grid state variables for each one of the stochastic scenarios obtained in step a), both non-zero values of grid state variables estimated in step c) and measured values obtained in step b), for each particular stochastic scenario being used as input for estimating the grid state variables for each one of the stochastic scenarios.

7. The method for determining an optimal placement of measurement units according to claim 6, wherein it comprises the following additional sub-step between sub-step b) and sub-step c):

- add random noise representative of measurement error to the "measured values" calculated in sub-step b).

8. The method for determining an optimal placement of measurement units according to claim 6 or 7, wherein it comprises one or the other of the following alternative sub-steps between sub-step c) and sub-step d):

- if the optimization problem identified in sub-step c) makes the power distribution grid controllable, add a randomly placed measurement unit to the hypothetical monitoring infrastructure and return to sub-step a);
- if the optimization problem identified in sub-step c) does not make the power distribution grid controllable, remove the last added measurement unit from the hypothetical monitoring infrastructure and go on to sub-step d).

9. The method for determining an optimal placement of measurement units according to any one of claims 6, 7 and 8, wherein it comprises, after sub-step d), one or the other of the following alternative sub-steps:

- if the objective function identified in sub-step d) does not make the power distribution grid observable, replace a measurement unit of the hypothetical monitoring infrastructure by a randomly placed other measurement unit, and return to sub-step a).
- if the objective function identified in sub-step d) makes the power distribution grid observable, move on to step IV.

10. The method for determining an optimal placement of measurement units according to claim 9, wherein the measurement unit that is replaced by a randomly placed other measurement unit is the remaining last added measurement unit.

11. The method for determining an optimal placement of measurement units according to any one of the preceding claims, wherein

- each measurement unit is arranged to measure the voltage at a particular node, called the nodal voltage, and currents, called branch currents, flowing into or out of that particular node either from loads or generations at that particular node, or through branches that are incident on that particular node; and
- wherein a state of the power distribution grid is defined by the values of all nodal voltages and branch active and reactive powers, or equivalently by the values of all nodal voltages, branch currents and phase differences between each particular nodal voltage and branch currents flowing into or out of that particular node.

**Patentansprüche**

1. Verfahren zur Bestimmung einer optimalen Anordnung von Messeinheiten zur Schätzung des Zustands eines physikalischen Stromverteilungsnetzes, das einen Satz von Knoten und einen Satz von Zweigen aufweist, wobei das Verfahren die folgenden Schritte aufweist:

I. Bereitstellung eines Modells des Stromverteilungsnetzes, das die Topologie (Knoten), die Leitungen mit ihren Widerständen und Induktivitäten und ihrer Nennleistung sowie die Nennleistung der angeschlossenen Lasten und Generationen an jedem Knoten aufweist;

II. Festlegung einer hypothetischen Überwachungsinfrastruktur für das Modell des Stromverteilungsnetzes, wobei die hypothetische Überwachungsinfrastruktur mindestens eine zufällig angeordnete Messeinheit aufweist, wobei jeder Knoten des Stromverteilungsnetzes, der mit einer Messeinheit gemäß der hypothetischen Überwachungsinfrastruktur ausgestattet ist, im Folgenden als "Messknoten" bezeichnet wird;

III. Bewertung, ob die Anordnung der mindestens einen Messeinheit in der Überwachungsinfrastruktur mit einem zweistufigen Verfahren zur Zustandsschätzung kompatibel ist, wobei die erste Stufe des Verfahrens darin besteht, eine Minimum Norm SE für jedes Szenario zu implementieren, das in einem Satz von stochastischen Szenarien für Lasten und Generationen aufweist, wobei die Minimum Norm SE als Eingang für jedes bestimmte Szenario Messdaten verwendet, die dem bestimmten Szenario entsprechen, da das Ergebnis der ersten Stufe kontrollierbar sein muss, damit die Anordnung der mindestens einen Messeinheit mit dem zweistufigen SE-Verfahren kompatibel ist, und wobei die zweite Stufe des Verfahrens darin besteht, einen gewichteten kleinsten Quadrate (WLS) SE für jedes Szenario im Satz von stochastischen Szenarien zu implementieren, wobei als Eingang für jedes bestimmte Szenario Messdaten, die dem bestimmten Szenario entsprechen, und Nicht-Null-Werte, die in der ersten Stufe des Verfahrens für das bestimmte Szenario geschätzten werden, verwendet werden, da das Ergebnis der zweiten Stufe beobachtbar sein muss, damit die Anordnung der mindestens einen Messeinheit mit dem zweistufigen SE-Verfahren kompatibel ist;

IV. wenn die Anordnung der mindestens einen Messeinheit mit dem zweistufigen Verfahren zur Zustandsschätzung kompatibel ist, Bestimmung des Mittelwerts und der Standardabweichung des Zustandsschätzungsfehlers der zweiten Stufe und Aufzeichnung der Anordnung der mindestens einen Messeinheit zusammen mit dem Mittelwert und der Standardabweichung; Wiederholung der Schritte II bis IV, bis mindestens einhundert Anordnungen von Messeinheiten aufgezeichnet worden sind;

V. Auswahl einer Anordnung von Messeinheiten, die eine minimale Anzahl von Messeinheiten aus den erfassten Anordnungen von Messeinheiten, aufweist, die die Bedingung $|\mu_s| < A$, mit $A \in R^+$, und/oder die Bedingung $|\sigma_s| < B$, mit $B \in R^+$, erfüllen;

VI. Bereitstellung des physischen Stromverteilungsnetzes mit einer Überwachungsinfrastruktur, die Messeinheiten aufweist, die entsprechend der in Schritt V ausgewählten Anordnung von Messeinheiten angeordnet sind.

2. Verfahren zur Bestimmung einer optimalen Anordnung von Messeinheiten nach Anspruch 1, wobei bei der Implementierung von Schritt V die Anordnung von Messeinheiten, die eine minimale Anzahl von Messeinheiten aufweist, aus den erfassten Anordnungen von Messeinheiten ausgewählt wird, die auch die Bedingung $|\mu_s| < R \cdot \sigma_s$, erfüllen, mit $R \in R^+$ (zum Beispiel $|\mu_s| < 3 \cdot \sigma_s$).

3. Verfahren zur Bestimmung einer optimalen Anordnung von Messeinheiten nach Anspruch 1 oder 2, wobei es einen zusätzlichen Schritt zwischen den Schritten I und V aufweist, wobei der zusätzliche Schritt darin besteht:

- Bestimmung von "$r$" auf der Grundlage einer Schätzung der Anzahl der Zweige, die auf Stau oder Rückfluss überwacht werden sollten; und

wobei bei der Implementierung von Schritt V die Anordnung von Messeinheiten, die eine minimale Anzahl von Messeinheiten aufweist, aus den erfassten Anordnungen von Messeinheiten ausgewählt wird, die auch mindestens eine der beiden Bedingungen $|\mu_s - r \cdot \sigma_s| < \varepsilon$ und $|\mu_s + r \cdot \sigma_s| < \varepsilon$ (zum Beispiel $|\mu_s - r \cdot \sigma_s| < 10^{-3}$ und $|\mu_s + r \cdot \sigma_s| < 10^{-3}$) erfüllen.

4. Verfahren zur Bestimmung einer optimalen Anordnung von Messeinheiten nach Anspruch 3, wobei der zusätzliche Schritt der Bestimmung von "$r$" die folgenden Teilschritte aufweist:

- Identifizierung von Zweigen des Stromverteilungsnetzes, die am stärksten von Staus oder inversem Leistungsfluss betroffen sind;
- Schätzung des Prozentsatz der Wirk- und Blindleistungsflüsse durch die identifizierten Zweige, die mit hoher Genauigkeit überwacht werden sollten;
- Bestimmung von $r$ als Verhältnis der Standardabweichung ($\sigma_s$) zum Mittelwert ($\mu_s$) einer Normalverteilung, so dass der Prozentsatz der Fälle in der Normalverteilung, die in einer Permittanz enthalten sind, die im Mittelpunkt steht und eine Breite von nicht mehr als etwa $0{,}5 \cdot \sigma_s$ hat, gleich dem geschätzten Prozentsatz ist.

5. Verfahren zur Bestimmung einer optimalen Anordnung von Messeinheiten nach Anspruch 4, wobei die Permittanz eine Breite von $0.5 \cdot \sigma_s$ hat.

6. Verfahren zur Bestimmung einer optimalen Anordnung von Messeinheiten nach einem der vorhergehenden Ansprüche, wobei Schritt III die folgenden Teilschritte aufweist:

    a) Erhalten eines Satz von stochastischen Szenarien für Lasten und Generationen im Stromverteilungsnetz;
    b) Verwendung eines Leistungsflussalgorithmus zur Simulation des Leistungsflusses im Verteilungsnetz für jedes der in dem Satz enthaltenen stochastischen Szenarien, um die jeweiligen Zustände des Stromverteilungsnetzes zu berechnen, wobei die für die Messknoten berechneten Werte der Knotenspannungen sowie die für die auf die Messknoten einfallenden Zweige berechneten Werte der Zweigströme im Folgenden als "Messwerte" und die entsprechenden Werte der Wirk- und Blindleistungen ebenfalls als "Messwerte" bezeichnet werden;
    c) Verwendung von Minimum Norm zur Identifizierung eines Optimierungsproblems für die Zustände des Stromverteilungsnetzes sowie zur Schätzung der Netzzustandsvariablen für jedes der in Schritt a) erhaltenen stochastischen Szenarien, wobei die in Schritt b) für jedes bestimmte stochastische Szenario erhaltenen Messwerte als Eingang für die Schätzung der Netzzustandsvariablen für das bestimmte stochastische Szenario verwendet werden;
    d) wenn das in Teilschritt c) identifizierte Optimierungsproblem das Stromverteilungsnetz kontrollierbar macht, Verwendung der gewichteten kleinsten Quadrate, um eine Zielfunktion für die Zustände des Stromverteilungsnetzes zu identifizieren, sowie um die Netzzustandsvariablen für jedes der in Schritt a) erhaltenen stochastischen Szenarien zu schätzen, wobei sowohl die in Schritt c) geschätzten Nicht-Null-Werte der Netzzustandsvariablen als auch die in Schritt b) erhaltenen Messwerte für jedes bestimmte stochastische Szenario als Eingang für die Schätzung der Netzzustandsvariablen für jedes der stochastischen Szenarien verwendet werden.

7. Verfahren zur Bestimmung einer optimalen Anordnung von Messeinheiten nach Anspruch 6, wobei es den folgenden zusätzlichen Teilschritt zwischen Teilschritt b) und Teilschritt c) aufweist:

    - Hinzufügen von Zufallsrauschen, das den Messfehler repräsentiert, zu den in Teilschritt b) berechneten "Messwerten".

8. Verfahren zur Bestimmung einer optimalen Anordnung von Messeinheiten nach Anspruch 6 oder 7, wobei es den einen oder den anderen der folgenden alternativen Teilschritte zwischen Teilschritt c) und Teilschritt d) aufweist:

    - wenn das in Teilschritt c) identifizierte Optimierungsproblem das Stromverteilungsnetz kontrollierbar macht, Hinzufügen einer zufällig angeordneten Messeinheit zu der hypothetischen Überwachungsinfrastruktur und Rückkehr zu Teilschritt a);
    - wenn das in Teilschritt c) identifizierte Optimierungsproblem das Stromverteilungsnetz nicht kontrollierbar macht, Entfernen der letzten hinzugefügten Messeinheit aus der hypothetischen Überwachungsinfrastruktur und Weitergehen zu Teilschritt d).

9. Verfahren zur Bestimmung einer optimalen Anordnung von Messeinheiten nach einem der Ansprüche 6, 7 und 8, wobei es nach Teilschritt d) den einen oder den anderen der folgenden alternativen Teilschritte aufweist:

    - wenn die in Teilschritt d) identifizierte Zielfunktion das Stromverteilungsnetz nicht beobachtbar macht, Ersetzung einer Messeinheit der hypothetischen Überwachungsinfrastruktur durch eine zufällig angeordnete andere Messeinheit und Rückkehr zu Teilschritt a);
    - wenn die in Teilschritt d) identifizierte Zielfunktion das Stromverteilungsnetz beobachtbar macht, Übergang zu Schritt IV.

10. Verfahren zur Bestimmung einer optimalen Anordnung von Messeinheiten nach Anspruch 9, wobei die Messeinheit, die durch eine zufällig angeordnete andere Messeinheit ersetzt wird, die verbleibende, zuletzt hinzugefügte Messeinheit ist.

11. Verfahren zur Bestimmung einer optimalen Anordnung von Messeinheiten nach einem der vorhergehenden Ansprüche, wobei

- jede Messeinheit so angeordnet ist, dass sie die Spannung an einem bestimmten Knoten, die so genannte Knotenspannung, und Ströme, die so genannte Zweigströme, misst, die in diesen bestimmten Knoten hinein oder aus ihm heraus fließen, entweder von Lasten oder Generationen an diesem bestimmten Knoten oder durch Zweige, die auf diesen bestimmten Knoten einfallen; und

- wobei ein Zustand des Stromverteilungsnetzes durch die Werte aller Knotenspannungen und Wirk- und Blindleistungen der Zweige oder gleichwertig durch die Werte aller Knotenspannungen, Zweigströme und Phasendifferenzen zwischen jeder einzelnen Knotenspannung und den Zweigströmen, die in diesen bestimmten Knoten hinein oder aus ihm heraus fließen, definiert ist.

**Revendications**

1. Procédé de détermination d'un positionnement optimal d'unités de mesure pour estimer l'état d'un réseau de distribution d'électricité physique comprenant un ensemble de noeuds et un ensemble de dérivations, le procédé comprenant les étapes suivantes :

   I. la fourniture d'un modèle du réseau de distribution d'électricité comprenant la topologie (noeuds), les lignes avec leur résistance, leur inductance et leur capacité nominale, ainsi que la capacité nominale de charges et de générations connectées au niveau de chaque noeud ;

   II. la spécification d'une infrastructure de surveillance hypothétique pour le modèle du réseau de distribution d'électricité, l'infrastructure de surveillance hypothétique comprenant au moins une unité de mesure positionnée aléatoirement, dans lequel tout noeud du réseau de distribution d'électricité qui est équipé d'une unité de mesure selon l'infrastructure de surveillance hypothétique est dénommé ci-après « noeud de mesure » ;

   III. le fait d'évaluer si le positionnement de l'au moins une unité de mesure dans l'infrastructure de surveillance est compatible avec un procédé d'estimation d'état en deux phases, dans lequel la première phase du procédé consiste à mettre en oeuvre une SE de norme minimale pour chaque scénario compris dans un ensemble de scénarios stochastiques pour des charges et des générations, la SE de norme minimale utilisant comme entrée pour chaque scénario particulier, des données mesurées correspondant au scénario particulier, étant donné que pour que le positionnement de l'au moins une unité de mesure soit compatible avec le procédé de SE en deux phases, le résultat de la première phase doit être contrôlable, et dans lequel la deuxième phase du procédé consiste à mettre en oeuvre une SE des moindres carrés pondérés (WLS) pour chaque scénario dans l'ensemble de scénarios stochastiques, en utilisant comme entrée pour chaque scénario particulier, les données mesurées correspondant au scénario particulier et des valeurs non nulles estimées lors de la première phase du procédé pour le scénario particulier, étant donné que pour que le positionnement de l'au moins une unité de mesure soit compatible avec le procédé de SE en deux phases, le résultat de la deuxième phase doit être observable ;

   IV. si le positionnement de l'au moins une unité de mesure est compatible avec le procédé d'estimation d'état en deux phases, la détermination de la moyenne et de l'écart type de l'erreur d'Estimation d'état de deuxième phase, et l'enregistrement du positionnement de l'au moins une unité de mesure conjointement avec ladite moyenne et ledit écart type ; la répétition des étapes II à IV jusqu'à ce qu'au moins cent positionnements d'unités de mesure aient été enregistrés ;

   V. la sélection d'un positionnement d'unité de mesure qui comprend un nombre minimal d'unités de mesure parmi les positionnements d'unités de mesure qui satisfont la condition $|\mu_s| < A$, avec $A \in R^+$, et/ou la condition $|\sigma_s| < B$, avec $B \in R^+$ ;

   VI. la fourniture, au réseau de distribution d'électricité physique, d'une infrastructure de surveillance comprenant des unités de mesure positionnées selon le positionnement d'unité de mesure sélectionné à l'étape V.

2. Procédé de détermination d'un positionnement optimal d'unités de mesure selon la revendication 1, dans lequel lors de la mise en oeuvre de l'étape V, le positionnement d'unité de mesure qui comprend un nombre minimal d'unités de mesure est sélectionné parmi les positionnements d'unités de mesure enregistrés qui satisfont également la condition $|\mu_s| < R \cdot \sigma_s$, avec $R \in R^+$ (par exemple $|\mu_s| < 3 \cdot \sigma_s$).

3. Procédé de détermination d'un positionnement optimal d'unités de mesure selon la revendication 1 ou 2, dans lequel il comprend une étape supplémentaire entre les étapes I et V, ladite étape supplémentaire consistant à :

   - déterminer « r » sur la base d'une évaluation du nombre de dérivations qui doivent être surveillées à la recherche d'une congestion ou d'un flux inverse ; et

   dans lequel, lors de la mise en oeuvre de l'étape V, le positionnement d'unité de mesure qui comprend un nombre minimal d'unités de mesure est sélectionné parmi les positionnements d'unités de mesure enregistrés qui satisfont au moins l'une des deux conditions $|\mu_s - r \cdot \sigma_s| < \varepsilon$ et $|\mu_s + r \cdot \sigma_s| < \varepsilon$ (par exemple $|\mu_s - r \cdot \sigma_s| < 10^{-3}$ et $|\mu_s + r \cdot \sigma_s| < 10^{-3}$).

4. Procédé de détermination d'un positionnement optimal d'unités de mesure selon la revendication 3, dans lequel l'étape supplémentaire consistant à déterminer « r » comprend les sous-étapes suivantes :

- l'identification de dérivations du réseau de distribution d'électricité qui sont les plus exposées à une congestion ou à un flux de puissance inverse ;
- l'estimation du pourcentage des flux de puissance active et réactive à travers les dérivations identifiées, qui doivent être surveillés avec une grande précision ;
- la détermination de r en tant que rapport de l'écart type ($\sigma_s$) à la moyenne ($\mu_s$) d'une distribution normale, de sorte que le pourcentage de cas dans la distribution normale qui sont contenus dans une permittivité centrée à zéro et ayant une largeur non supérieure à environ $0,5 \cdot \sigma_s$ soit égal audit pourcentage estimé.

5. Procédé de détermination d'un positionnement optimal d'unités de mesure selon la revendication 4, dans lequel la permittivité a une largeur de $0,5 \cdot \sigma_s$.

6. Procédé de détermination d'un positionnement optimal d'unités de mesure selon l'une quelconque des revendications précédentes, dans lequel l'étape III comprend les sous-étapes suivantes :

a) l'obtention d'un ensemble de scénarios stochastiques pour des charges et des générations dans le réseau de distribution d'électricité ;
b) l'utilisation d'un algorithme de flux de puissance afin de simuler le flux de puissance dans le réseau de distribution pour chacun des scénarios stochastiques compris dans l'ensemble de façon à calculer les états respectifs du réseau de distribution d'électricité, les valeurs de tensions nodales calculées pour des noeuds de mesure, ainsi que les valeurs de courants de dérivation calculés pour des dérivations incidentes sur les noeuds de mesure, étant dénommées ci-après « valeurs mesurées », et les valeurs correspondantes de puissances active et réactive étant également dénommées « valeurs mesurées » ;
c) l'utilisation d'une Norme minimale pour identifier un problème d'optimisation des états du réseau de distribution d'électricité, ainsi que pour estimer les variables d'état de réseau pour chacun des scénarios stochastiques obtenus à l'étape a), les valeurs mesurées obtenues à l'étape b) pour chaque scénario stochastique étant utilisées comme entrée pour estimer les variables d'état de réseau pour le scénario stochastique particulier ;
d) si le problème d'optimisation identifié à la sous-étape c) rend le réseau de distribution d'électricité contrôlable, l'utilisation des moindres carrés pondérés pour identifier une fonction objectif pour les états du réseau de distribution d'électricité, ainsi que pour estimer les variables d'état de réseau pour chacun des scénarios stochastiques obtenus à l'étape a), les valeurs non nulles des variables d'état de réseau estimées à l'étape c) et les valeurs mesurées obtenues à l'étape b), pour chaque scénario stochastique particulier étant utilisées comme entrée pour estimer les variables d'état de réseau pour chacun des scénarios stochastiques.

7. Procédé de détermination d'un positionnement optimal d'unités de mesure selon la revendication 6, dans lequel il comprend la sous-étape supplémentaire suivante entre la sous-étape b) et la sous-étape c) :

- l'ajout d'un bruit aléatoire représentatif d'une erreur de mesure aux « valeurs mesurées » calculées à la sous-étape b).

8. Procédé de détermination d'un positionnement optimal d'unités de mesure selon la revendication 6 ou 7, dans lequel il comprend l'un ou l'autre des sous-étapes alternatives suivantes entre la sous-étape c) et la sous-étape d) :

- si le problème d'optimisation identifié à la sous-étape c) rend le réseau de distribution d'électricité contrôlable, l'ajout d'une unité de mesure positionnée aléatoirement à l'infrastructure de surveillance hypothétique et le retour à la sous-étape a) ;
- si le problème d'optimisation identifié à la sous-étape c) ne rend pas le réseau de distribution d'électricité contrôlable, la suppression de la dernière unité de mesure ajoutée de l'infrastructure de surveillance hypothétique et le passage à la sous-étape d).

9. Procédé de détermination d'un positionnement optimal d'unités de mesure selon l'une quelconque des revendications 6, 7 et 8, dans lequel il comprend, après la sous-étape d), l'une ou l'autre des sous-étapes alternatives suivantes :

- si la fonction objectif identifiée à la sous-étape d) ne rend pas le réseau de distribution d'électricité contrôlable, le remplacement d'une unité de mesure de l'infrastructure de surveillance hypothétique par une autre unité de mesure positionnée aléatoirement, et le retour à la sous-étape a) ;

- si la fonction objectif identifiée à la sous-étape d) rend le réseau de distribution d'électricité observable, le passage à l'étape IV.

**10.** Procédé de détermination d'un positionnement optimal d'unités de mesure selon la revendication 9, dans lequel l'unité de mesure qui est remplacée par une autre unité de mesure positionnée aléatoirement est la dernière unité de mesure ajoutée restante.

**11.** Procédé de détermination d'un positionnement optimal d'unités de mesure selon l'une quelconque des revendications précédentes, dans lequel

- chaque unité de mesure est agencée pour mesurer la tension au niveau d'un noeud particulier, appelée tension nodale, et des courants, appelés courants de dérivation, circulant dans ou en dehors de ce noeud particulier soit à partir de charges ou de générations au niveau de ce noeud particulier, soit à travers des dérivations qui sont incidentes sur ce noeud particulier ; et

- dans lequel un état du réseau de distribution d'électricité est défini par les valeurs de l'ensemble des tensions nodales et des puissances active et réactive de dérivation, ou de façon équivalente par les valeurs de l'ensemble des tensions nodales, des courants de dérivation et des différences de phase entre chaque tension nodale particulière et des courants de dérivation circulant dans ou en dehors de ce noeud particulier.

Fig. 1

# Fig. 2

01 → Provide a model of the distribution grid

Specify a probationary measurement-unit layout

02

03 Test whether the layout is compatible with the two-stage SE method. If confirmed, record the layout along with the distribution of the SE error.

Determine « r » based on an appraisal of the number of relevant branches.

06

The number of recorded layouts has reached 100. — No

Yes

04 → Select all the recorded layouts for which the condition $|\mu_s| < R \cdot \sigma_s$, as well as one of the conditions $|\mu_s - r \cdot \sigma_s| < \varepsilon$ or $|\mu_s + r \cdot \sigma_s| < \varepsilon$ are satisfied, and from the selected layouts, choose the one with the minimum number of measurement units.

05 → Deploy measurement units in the distribution grid according to the chosen layout.

Fig. 3A

Fig. 3B

## Fig. 4

start

Provide the model of the grid with a hypothetical monitoring infrastructure comprising at least one randomly placed measurement unit — 11

Obtain a sample of operating scenarios for the loads and generations — 12

Run a power flow algorithm to compute the state of the grid for each scenario — 13

Add random noise representative of measurement error — 14

Use Minimum Norm to estimate the grid state variables for each one of the operating scenarios — 15

Controllable? — 16
Yes / No

Run WLS-SE with the measurements and the MInNormSE data — 17

Observable? — 18
Yes / No

record the measurement-unit layout, as well as μ and σ for the calculated state estimation errors — 19

end

EP 4 160 867 B1

# Fig. 5

**21** — Provide the model of the grid with a hypothetical monitoring infrastructure

**22** — Obtain a random sample of operating scenarios for the loads and generations

**23** — Run a power flow algorithm to compute the state of the grid for each scenario

**24** — Add random noise representative of measurement error

**25** — Use Minimum Norm to estimate the grid state variables for each one of the operating scenarios

**26** — Add a randomly placed measurement unit to the hypothetical monitoring infrastructure

**27** — Remove the last added measurement unit from the hypothetical monitoring infrastructure

**28** — Run WLS-SE with the measurements and the MInNormSE data

**29** — Replace the remaining last added measurement unit by a new randomly placed measurement unit

**30** — record the measurement-unit layout, as well as $\mu$ and $\sigma$ for the calculated state estimation errors

start

Controllable? — No / Yes

Observable? — Yes / No

end

Fig. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2021083474 A1

### Non-patent literature cited in the description

- **I. ROYTELMAN ; S. SHAHIDEHPOUR.** State estimation for electric power distribution systems in quasi real-time conditions. *IEEE Transactions on Power Delivery,* 1993, vol. 8 (4), 2009-2015
- **C. LU ; J. TENG ; W.-H. LIU.** Distribution system state estimation. *IEEE Transactions on Power systems,* 1995, vol. 10 (1), 229-240
- **K. LI.** State estimation for power distribution system and measurement impacts. *IEEE Transactions on Power Systems,* 1996, vol. 11 (2), 911-916
- **H. WANG ; N. N. SCHULZ.** A revised branch current-based distribution system state estimation algorithm and meter placement impact. *IEEE Transactions on Power Systems,* 2004, vol. 19 (1), 207-213
- **J. WU ; Y. HE ; N. JENKINS.** A robust state estimator for medium voltage distribution networks. *IEEE Transactions on Power Systems,* 2013, vol. 28 (2), 1008-1016
- **D. A. HAUGHTON ; G. T. HEYDT.** A linear state estimation formulation for smart distribution systems. *IEEE Transactions on Power Systems,* 2012, vol. 28 (2), 1187-1195
- **M. C. DE ALMEIDA ; L. F. OCHOA.** An improved three-phase AMB distribution system state estimator. *IEEE Transactions on Power Systems,* 2016, vol. 32 (2), 1463-1473
- **S. PRASAD ; D. V. KUMAR.** Trade-offs in PMU and IED deployment for active distribution state estimation using multi-objective evolutionary algorithm. *IEEE Transactions on Instrumentation and Measurement,* 2018, vol. 67 (6), 1298-1307
- **A. S. ZAMZAM ; X. FU ; N. D. SIDIROPOULOS.** Data-driven learning-based optimization for distribution system state estimation. *IEEE Transactions on Power Systems,* 2019, vol. 34 (6), 4796-4805
- **J. LIU ; J. TANG ; F. PONCI ; A. MONTI ; C. MUSCAS ; P. A. PEGORARO.** Trade-offs in PMU deployment for state estimation in active distribution grids. *IEEE Transactions on Smart Grid,* 2012, vol. 3 (2), 915-924
- **J. LIU ; F. PONCI ; A. MONTI ; C. MUSCAS ; P. A. PEGORARO ; S. SULIS.** Optimal meter placement for robust measurement systems in active distribution grids. *IEEE Transactions on Instrumentation and Measurement,* 2014, vol. 63 (5), 1096-1105
- **R. SINGH ; B. C. PAL ; R. B. VINTER.** Measurement placement in distribution system state estimation. *IEEE Transactions on Power Systems,* 2009, vol. 24 (2), 668-675
- **J. A. TAYLOR.** Convex optimization of power systems. Cambridge University Press, 2015
- **A. VON MEIER ; E. STEWART ; A. MCEACHERN ; M. ANDERSEN ; L. MEHRMANESH.** Precision micro-synchrophasors for distribution systems: A summary of applications. *IEEE Transactions on Smart Grid,* 2017, vol. 8 (6), 2926-2936
- **A. MONTICELLI.** Electric power system state estimation. *Proceedings of the IEEE,* 2000, vol. 88 (2), 262-282
- **P. A. PEGORARO et al.** Bayesian approach for distribution system state estimation with non-Gaussian uncertainty models. *IEEE Transactions on Instrumentation and Measurement,* 2017, vol. 66 (11), 2957-2966
- **K. DEHGHANPOUR ; Z. WANG ; J. WANG ; Y. YUAN ; F. BU.** A survey on state estimation techniques and challenges in smart distribution systems. *IEEE Transactions on Smart Grid,* 2018, vol. 10 (2), 2312-2322
- **L. W. GAN ; S. H. LOW ; LEEE.** Convex Relaxations and Linear Approximation for Optimal Power Flow in Multiphase Radial Networks. *Power System Computation Conference (Pscc),* 2014